# EUROPEAN PATENT APPLICATION

(11) **EP 2 631 328 A1**
(43) Date of publication of application: **28.08.2013**
(21) Application number: 13156457.7
(22) Date of filing: 22.02.2013
(51) Int. Cl.: C23C 14/34, H01J 37/34

(54) **Composite target and method for manufacturing the same**

(30) Priority: 24.02.2012 TW 101106238
(71) Applicant: Sumika Technology Co., Ltd., Tainan City 74144 (TW)
(72) Inventor: Yang, Ching-Ho, 704 Tainan City (TW); Sun, Hsuan-Cheng, 811 Kaohsiung City (TW); Wu, Chih-Wen, 709 Tainan City (TW); Su, Meng-Peng, 822 Kaohsiung City (TW); Weng, Chi-Hsiang, 711 Tainan City (TW)
(74) Representative: Granleese, Rhian Jane

(57) **Abstract**

A composite target and method for manufacturing the same are described, which manufactures the composite target according an etching condition of a waste target. The waste target is generated after an original target at least having a substrate layer and a metal layer is processed through a sputtering process by a sputtering apparatus with a first magnetic field line distribution. By determining the etching condition caused by the first magnetic field line distribution, a magnetic layer with a second magnetic field line distribution is decided to dispose on the original target. The metal layer is formed on the substrate layer and/or the magnetic layer. The substrate layer, the magnetic layer and the metal layer are combined by a connection layer to form the composite target. The composite target can provide the second magnetic field line distribution to adjust the first magnetic field line distribution.

## Description

### Field of the Invention

The present invention relates to a composite target and a method for manufacturing the same, and more particularly to a novel target and a method for manufacturing the same, in which the target can be uniformly consumed and a utilization rate of the target can be increased.

### Background of the Invention

Currently, a sputtering technique is one of main depositing coating techniques. The sputtering technique is wildly applied on the industrial production and the science study field. For example, a surface of a work piece can include a functional film thereon, such as a superhard film, a self-lubricating film, an anti-reflection film, a low-emissivity film, a transparent conductive film or a heat insulation film formed by sputtering.

In addition, a principle of the sputtering technique is to use plasma to ion bombard a target, which includes a substrate layer and a metal layer, to strike metal atoms of the metal layer and to make the metal atoms be out of the metal layer to form gas molecules, and then the gas molecules arrive at a substrate to be deposited. After sputtering processes including adhesion, absorption, surface migration and nucleation, a metal film having the metal atoms is finally formed on the substrate.

However, because the inherent deficiencies (such as there is a magnetic field existing on the sputtering apparatus) of the conventional sputtering technique, the target has disadvantages including a low target utilization rate, a slower deposition rate and a lower ionization rate. The target utilization rate is affected by the magnetic field on the sputtering apparatus, and the plasma is restricted within a local surface area of the metal layer, so that curved indentation consumption of the metal layer is caused, and the surface of the metal layer is consumed non-uniformly. For example, the middle area of the metal layer is consumed less, and the edge area of the metal layer is consumed too much. Currently, the best utilization rate of the target is only about from 20% to 25%, for example.

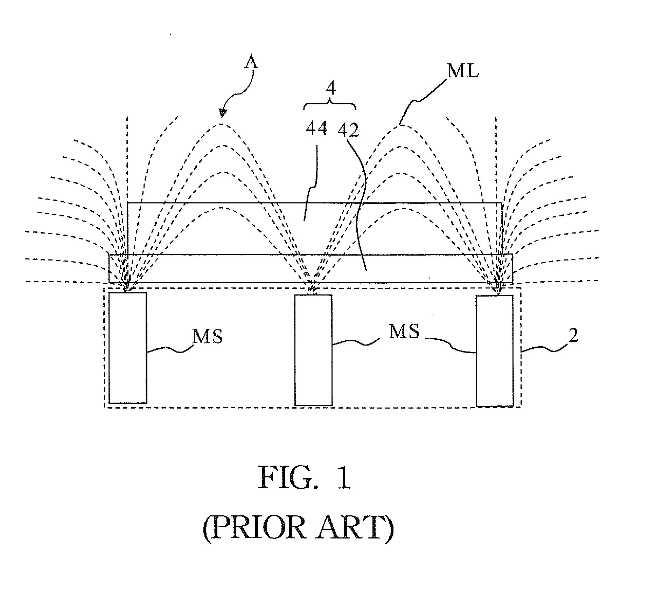

Refer to FIG. 1. FIG. 1 is a schematic diagram showing the configuration of a sputtering apparatus 2 and a target 4 in a conventional sputtering technique. The sputtering apparatus 2 has a magnetic field source MS that can generate a pattern of magnetic field lines ML. When the target 4 (including a substrate layer 42 and a metal layer 44) is disposed at one side of the sputtering apparatus 2, the magnetic field lines ML are formed on the target 4. According to the prior art, it is known that the sputtering is mainly occurred in the areas of the target, which are approximately parallel to the magnetic field lines ML.

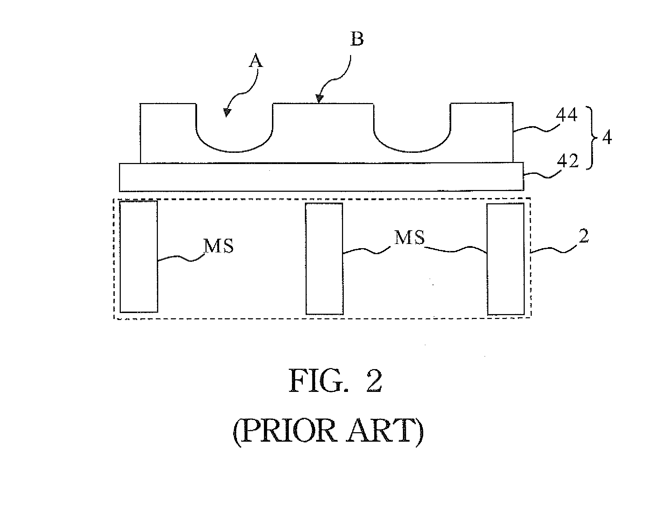

Simultaneously refer to FIG. 2. FIG. 2 shows the target 4 after the sputtering process is performed. The sputtering is mainly occurred in etching areas A of the target 4 (the areas of the target are parallel to the magnetic field lines ML), so that the etching rate of the etching areas A is obviously greater than that of etching area B (the areas of the target are non-parallel to the magnetic field lines ML). In order to prevent the sputtering apparatus from being damaged by etching the substrate layer 42 of the target 4 through the etching areas A, no matter whether a great deal of the unetched metal layer 44 is in the etching area B or not, the etched target 4 is abandoned. The abandoned target 4 is referred as a waste target in the industry.

In other words, the consumption rate of the thicknesses of two sides of the metal layer 42 is much greater than that of the thickness of a middle area of the metal layer 42. Unfortunately, when the etching areas A are approximately passed through (i.e., the etching areas cannot be etched any more), no matter whether the etching area B of the metal layer 42 has sufficient thicknesses for etching or not, the metal layer 42 is regarded as an abandoned target and cannot be used.

Furthermore, according to the aforementioned disadvantages, a prior art is provided to directly adjust the magnetic field lines ML of the sputtering apparatus 2. However, the target suppliers are usually not the manufacturers of the sputtering apparatus, so that the suppliers cannot get the related information about the magnetic field lines ML directly through the sputtering apparatus. Therefore, after the waste targets are recovered, the waste problem of the waste targets cannot be effectively solved.

Accordingly, it is needed to use a composite target and a method for manufacturing the same to solve the non-uniform consumption of the target in the prior art.

### Summary of the Invention

One objective of the present invention is to provide a method for manufacturing a composite target used to manufacture the composite target, which can be uniformly consumed, so as to achieve an effect of increasing a utilization rate of the target.

Another objective of the present invention is to provide the aforementioned method, which can effectively and uniformly consume the target without changing a distribution of magnetic field lines of a sputtering apparatus.

Still another objective of the present invention is to provide a composite target, in which an effect of uniformly using the target is achieved by dynamically adjusting a distribution of magnetic field lines on an original target.

Further another objective of the present invention is to provide the aforementioned composite target, in which a magnetic layer including a magnetic material is disposed on or embedded in a substrate layer to effectively use the target.

In order to achieve the aforementioned and other objects, the present invention provides a method for manufacturing a composite target, which manufactures the composite target according an etching condition of a waste target. The waste target is generated after an original target at least having a substrate layer and a metal layer is processed through a sputtering process by a sputtering apparatus with a first magnetic field line distribution. The method includes the following steps: determining the etching condition of the waste target caused by the first magnetic field line distribution to decide a second magnetic field line distribution, wherein the second magnetic field line distribution is used to adjust the first magnetic field line distribution applied on the composite target while being disposed on the sputtering apparatus; disposing a magnetic layer corresponding to the second magnetic field line distribution on the substrate layer of the original target; disposing the metal layer on the magnetic layer and the substrate layer; and disposing a connection layer among the substrate layer, the magnetic layer and the metal layer to combine the substrate layer, the magnetic layer and the metal layer to form the composite target. When the composite target is used to perform the sputtering process, the composite target with the second magnetic field line distribution adjusts the first magnetic field line distribution applied on the composite target into a third magnetic field line distribution.

Furthermore, in order to achieve the aforementioned and other objects, the present invention provides a composite target, which is provided to a sputtering apparatus with a first magnetic field line distribution for sputtering. The composite target includes a substrate layer, a magnetic layer, a metal layer and a connection layer. The substrate layer includes an embarkation surface and a carrying surface, wherein the embarkation surface is used to embark on the sputtering apparatus. The magnetic layer is disposed on the carrying surface of the substrate layer, wherein the magnetic layer generates a second magnetic field line distribution, and the second magnetic field line distribution is used to adjust the first magnetic field line distribution to a third magnetic field line distribution. The metal layer is disposed on the magnetic layer and the carrying surface of the substrate layer, wherein the metal layer has the second magnetic field line distribution. The connection layer is disposed among the substrate layer, the magnetic layer and the metal layer to connect the substrate layer, the magnetic layer and the metal layer.

As compared with the prior art, the composite target and the method for manufacturing the same of the present invention can directly and customizedly provide an original target with another magnetic field, which can adjust an original magnetic field line distribution of a sputtering apparatus, according to a shape of the original target without changing the original magnetic field line distribution of the sputtering apparatus in itself. Therefore, when the composite target is carried on the same sputtering apparatus, the utilization rate of the composite target is twice or triple (for example, about from 45% to 60%) as large as that of the original target in the prior art carried on the sputtering apparatus. In addition, the composite target of the present invention adjusts the magnetic field line distribution by disposing the magnetic layer on or embedding the magnetic layer in the substrate layer.

### Brief Description of the Drawings

FIG. 1 is a schematic diagram showing the configuration of a magnetic field installation in a conventional sputtering technique;
FIG. 2 is a schematic diagram showing the target after the conventional sputtering technique is performed;
FIG. 3 is a flowchart showing a method for manufacturing a composite target in accordance with a first embodiment of the present invention;
FIG. 4 is a schematic diagram showing a target condition of the target formed by the method in FIG. 3 after sputtering;
FIG. 5 is a schematic diagram showing a structure of a composite target in accordance with a first embodiment of the present invention;
FIG. 6(a) through FIG. 6(c) are schematic diagrams showing magnetic field line distributions;
FIG. 7(a) through 7(c) are schematic diagrams showing the structure of the composite target in FIG. 5;
FIG. 8(a) through FIG. 8(c) are schematic diagrams showing experiments of composite targets in accordance with a third embodiment of the present invention; and
FIG. 9 is a schematic diagram showing etching profiles of the composite targets in FIG. 8(a) through FIG. 8(c).

### Detailed Description of the Preferred Embodiment

In order to make the objects, features and advantages of the present invention be more readily appreciated as the same become better understood, the following detailed description is stated by reference to the following specific embodiments, when taken in conjunction with the accompanying drawings.

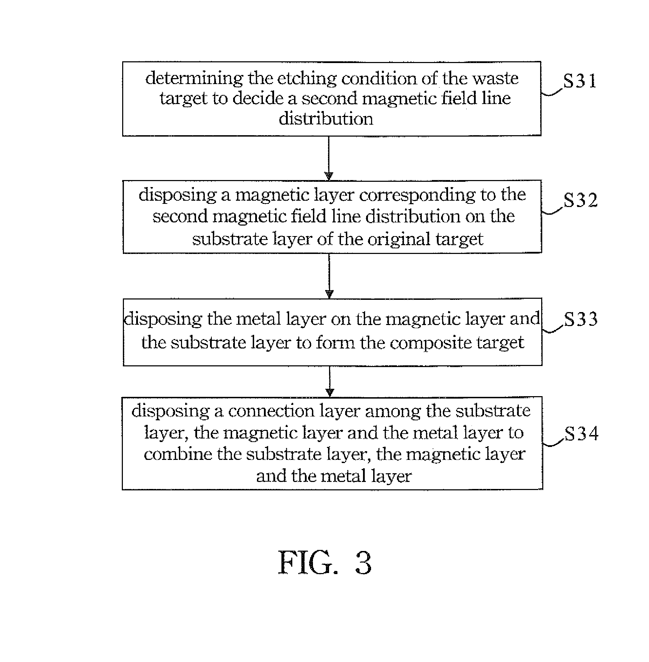

Refer to FIG. 3. FIG. 3 is a flowchart showing a method for manufacturing a composite target in accordance with a first embodiment of the present invention. In FIG. 3, the method of manufacturing the composite target manufactures a composite target according to an etching condition of a waste target, and the waste target is generated after an original target at least having a substrate layer and a metal layer is processed through a sputtering process by a sputtering apparatus with a first magnetic field line distribution. The first magnetic field line distribution is generated by a magnetic material, such as a magnet, disposed on the sputtering apparatus, such that when one original target (i.e., a conventional target structure) is carried by the sputtering apparatus, the first magnetic field line distribution can act on the original target, and the original target becomes the waste target after sputtering. Furthermore, the first magnetic field line distribution on the sputtering apparatus in the process of the original target becoming the waste target can be conjectured according to the etching condition of the waste target after sputtering.

The method for manufacturing the composite target starts from a step S31, which determines the etching condition of the waste target caused by the first magnetic field line distribution to decide a second magnetic field line distribution. The second magnetic field line distribution is used to adjust the first magnetic field line distribution applied on the composite target while being disposed on the sputtering apparatus. In the step, the first magnetic field line distribution (or referred as a magnetic field line pattern) applied on the original target is determined according to the etching condition of the waste target.

The illustration is made when taken in conjunction with the aforementioned FIG. 1 and FIG. 2. Referring to FIG. 2, the influence of the magnetic field lines ML (i.e., the first magnetic field line distribution in the step S31) on the target 4 before or during the target 4 can be conjectured according to the etching condition (i.e., the etching areas A and B) of the target 4 after the sputtering process. The influence causes non-uniform strikes, i.e. the consumption rate of the middle area of the metal layer 42 is obviously slower than that of the edge areas of the metal layer 42. In other words, because the metal layer 42 is affected by the magnetic field lines ML generated by the sputtering apparatus 2, it can be observed that the consumption rate of two sides of the metal layer 42 is obviously greater than that of the middle area of the metal layer 42. According to the determination result for the etching areas of the metal layer 42 in the aforementioned FIG. 2, a corresponding adjustment (also referred as a compensation correction) can be made based on the conjectured magnetic field lines ML. In other words, the second magnetic field line distribution is generated corresponding to the magnetic field lines ML according the consumption condition of the metal layer 42 desired to be adjusted (for example, the consumption rate of the middle portion of the metal layer is increased, and the consumption rate of the edge portion of the metal layer 42 is decreased).

For example, in order to improve the non-uniform consumption problem of the etching area B of the metal layer 42 in FIG. 2, the density of the original magnetic field lines ML is decreased to smooth the curves of the magnetic field lines ML, so as to broaden the range of the magnetic field lines ML parallel to the target 4, i.e. to broaden the etching areas A. In other words, with the effect of the second magnetic field line distribution, the distribution of the magnetic field lines ML can make the entire metal layer 42 be consumed uniformly. In addition, the consumption rate of the etching areas A is decreased, and the consumption rate of the etching area B is increased, so that the etching areas A is broadened, thereby prolonging life time (or referred as usage time) of the target 4.

Next, a step S32 is performed to dispose a magnetic layer corresponding to the second magnetic field line distribution on the substrate layer of the original target. In the step, the magnetic layer having the second magnetic field line distribution is disposed on the substrate layer of the original target according to the decided second magnetic field line distribution in the aforementioned step, so as to form the second magnetic field line distribution on the original target. In one embodiment, the magnetic layer may be locally formed on the substrate layer or embedded in the substrate layer to form a third magnetic field line distribution on the composite target when the composite substrate is disposed on the sputtering apparatus, in which the first magnetic field line distribution exists. The third magnetic field line distribution is generated due to the effects of the second magnetic field line distribution and the first magnetic field line distribution.

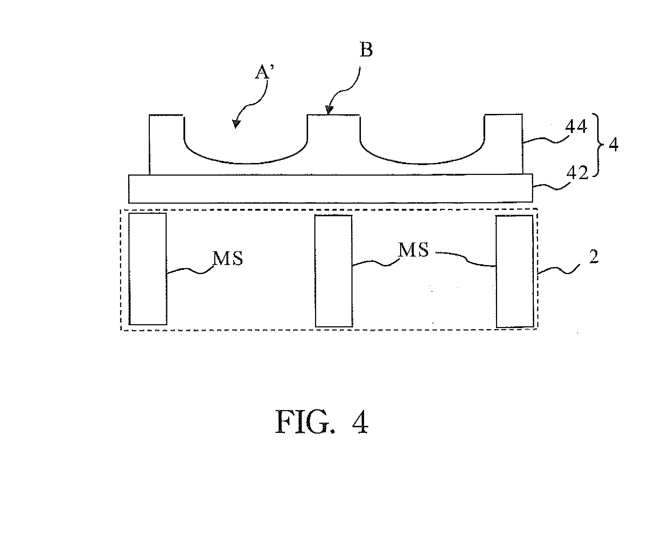

Next, a step S33 is performed to dispose a metal layer on the magnetic layer and the substrate layer. In the step, the metal layer is disposed on the substrate layer and/or the magnetic layer to make the metal layer, the magnetic layer and the substrate layer be all affected by the third magnetic field line distribution. For example, the third magnetic field line distribution is used to broaden the original etching areas A in FIG. 2 to etching areas A' in FIG. 4, to uniform the etching of the entire surface of the target 4, and to prolong the etching time of the target 4, i.e., to effectively increase the utilization rate of the target 4.

Then, a step S34 is performed to dispose a connection layer among the substrate layer, the magnetic layer and the metal layer to combine the substrate layer, the magnetic layer and the metal layer to form the composite target. In the step, the connection layer may be formed among the substrate layer, the magnetic layer and the metal layer to combine the substrate layer, the magnetic layer and the metal layer, so as to fix the substrate layer, the magnetic layer and the metal layer. In one embodiment, the connection layer connects the substrate layer and the magnetic layer. For example, the magnetic layer is fixed to the top of the substrate layer through the connection layer, or the magnetic layer is embedded and fixed in the substrate layer through the connection layer. In another embodiment, the connection layer may be filled into a vacant space of the substrate layer including no magnetic layer set therein. In addition, when the magnetic layer is embedded in the substrate layer, the metal layer may simultaneously connect with the magnetic layer and the substrate layer through the connection layer.

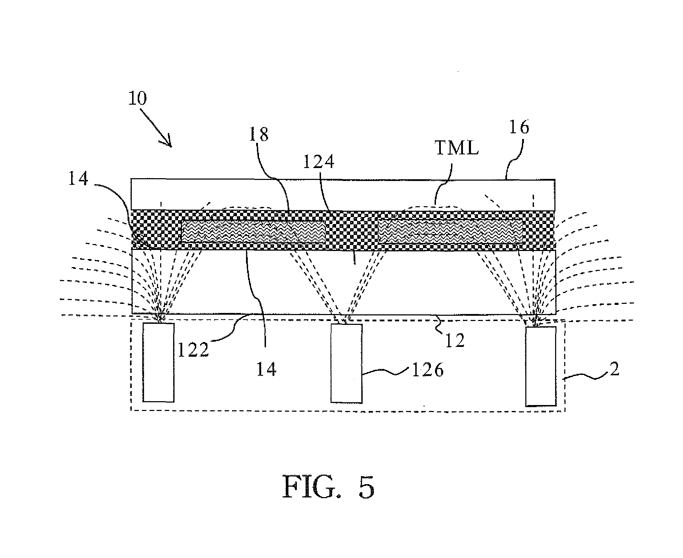

Refer to FIG. 5. FIG. 5 is a schematic diagram showing a structure of a composite target in accordance with a first embodiment of the present invention. As shown in FIG. 5, the composite target 10 is provided to a sputtering apparatus 2, which can generate a first magnetic field line distribution FML, for sputtering.

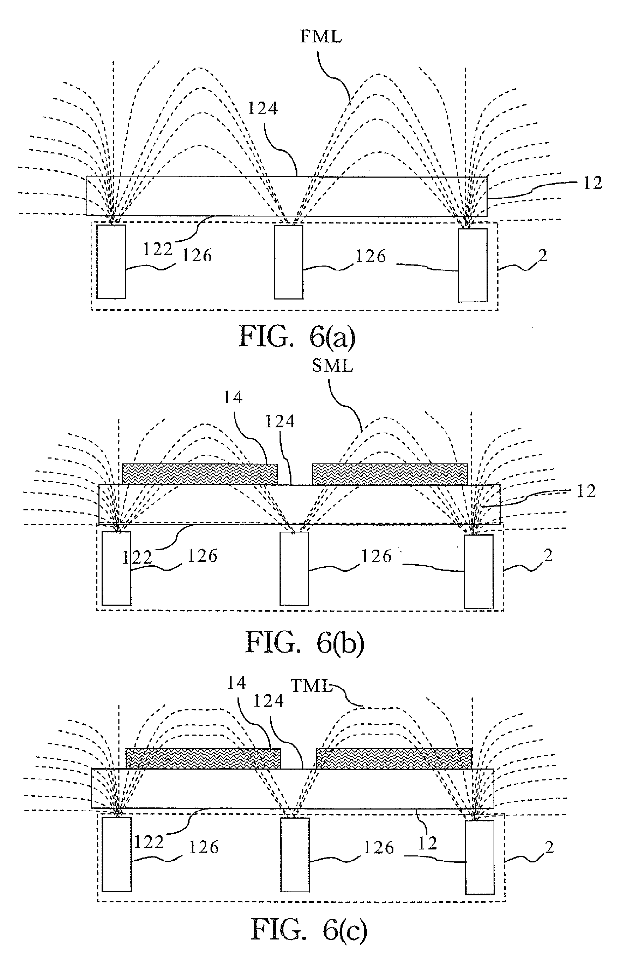

Simultaneously referring to FIG. 6(a), the composite target includes a substrate layer 12, a magnetic layer 14, a metal layer 16 and a connection layer 18. The substrate layer 12 has an embarkation surface 122 and a carrying surface 124, in which the embarkation surface 122 is used to embark on the sputtering apparatus 2 to make the carrying surface 124 of the substrate layer 12 have the first magnetic field line distribution FML due to the sputtering apparatus 2.

Next, referring to FIG. 6(b), the magnetic layer 14 is disposed on the carrying surface 124 of the substrate layer 12. The magnetic layer 14 has a second magnetic field line distribution SML (simultaneously referring to FIG. 6(b)), which is used to interacted with the first magnetic field line distribution FML to form a third magnetic field line distribution TML, such as shown in FIG. 6(c). A material of the magnetic layer 14 may be selected from a magnetic material group consisting of Fe, Co, Ni, stainless steel, and any combinations thereof.

Referring to FIG. 5 again, the metal layer 16 is disposed on the magnetic layer 14 and the carrying surface 124 of the substrate layer 12 to make the metal layer 16 have the third magnetic field line distribution TML in FIG. 6(c) due to the first magnetic field line distribution FML and the magnetic layer 14. A material of the metal layer 16 may be selected from a group consisting of Al, Cu, Mo, Ti, and any combinations thereof.

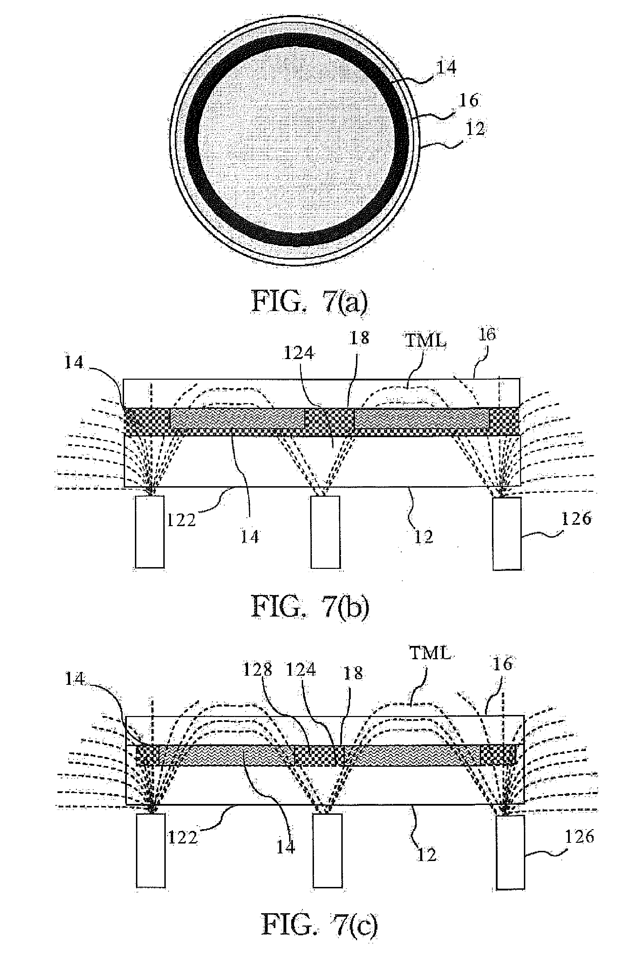

In another embodiment, the shape of the magnetic layer 14 may be at least one of a lattice shape, a grid shape, a ring shape and arbitrary shapes, and the magnetic layer 14 is disposed on the substrate layer 12 to form the second magnetic field line distribution SML on the substrate layer 12. In other words, no matter what the shape or the condition of the magnetic layer disposed on the substrate layer 12 is, the magnetic layer, which can generate the second magnetic field line distribution SML and the second magnetic field line distribution SML can interact with the first magnetic field line distribution FML, on the metal layer 16 is within the scope of the magnetic layer 14 of the present invention. Simultaneously referring to FIG. 7(a), the illustration is made by taking the circle metal layer 16 as an example. The magnetic layer 14 may be a circular body. It is worthy of note that there is no relationship between the shape of the magnetic layer 14 and the shape of the metal layer 16, i.e. the shape of the may not be limited to circle, and may be a lattice shape, a grid shape, a ring shape or the other arbitrary shape. The magnetic layer 14 is locally disposed on the substrate layer 12 (such as shown in FIG. 7(b)), or the magnetic layer 14 is embedded in the substrate layer 12 (such as shown in FIG. 7(c)) to make the substrate layer 12 have the third magnetic field line distribution TML.

Furthermore, the aspect of the magnetic layer 14 embedded in the substrate layer 12 may include a type, which the substrate layer 12 has a filling region 128 including at least one of a trench, a hole, a lattice and a grid, which can be filled with the magnetic layer 14, and the filling region 128 is used to make the magnetic layer 14 be embedded in the substrate layer 12 and is filled with the magnetic layer 14.

Referring to FIG. 5 again, the connection layer 18 is disposed among the substrate layer 12, the magnetic layer 14 and the metal layer 16 to connect the substrate layer 12, the magnetic layer 14 and the metal layer 16. In another embodiment, if the magnetic layer 14 is embedded in the substrate layer 12, the connection layer 18 is filled into the space of at least one of the trench and the hole, which is not filled up with the magnetic layer 14, to connect the substrate layer 12 and the magnetic layer 14.

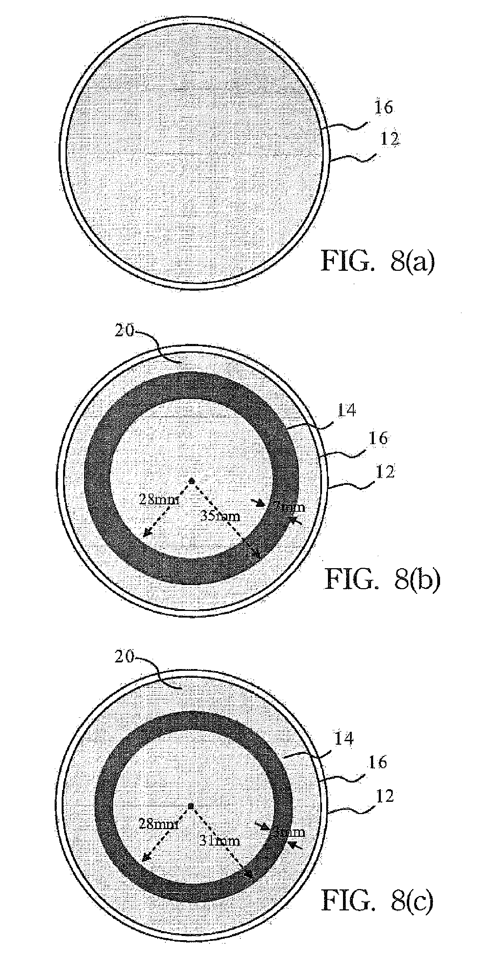

Refer to FIG. 8(a) through FIG. 8(c). FIG. 8(a) through FIG. 8(c) are schematic diagrams showing experiments of composite targets in accordance with a third embodiment of the present invention. As shown in FIG. 8(a) through FIG. 8(c), three different target structures are provided to do the tests of the utilization rate. The target structures include: an experimental group A, which is a target without any magnetic layer, such as shown in FIG. 8(a); an experimental group B, which is a composite target with a first circle magnetic layer, an inner circle of the first circle magnetic layer is apart from a center of the first circle magnetic layer by 28 mm, an outer circle of the first circle magnetic layer is apart from the center of the first circle magnetic layer by 35 mm, and the inner circle is apart from the outer circle by 7 mm, such as shown in FIG. 8(b); and an experimental group C, which is a composite target with a second circle magnetic layer, an inner circle of the second circle magnetic layer is apart from the center by 28 mm, an outer circle is apart from the center by 31 mm, and the inner circle is apart from the outer circle by 3 mm, such as shown in FIG. 8(c). Each target is a circle target having a diameter of 4 inches and a thickness of 3 mm.

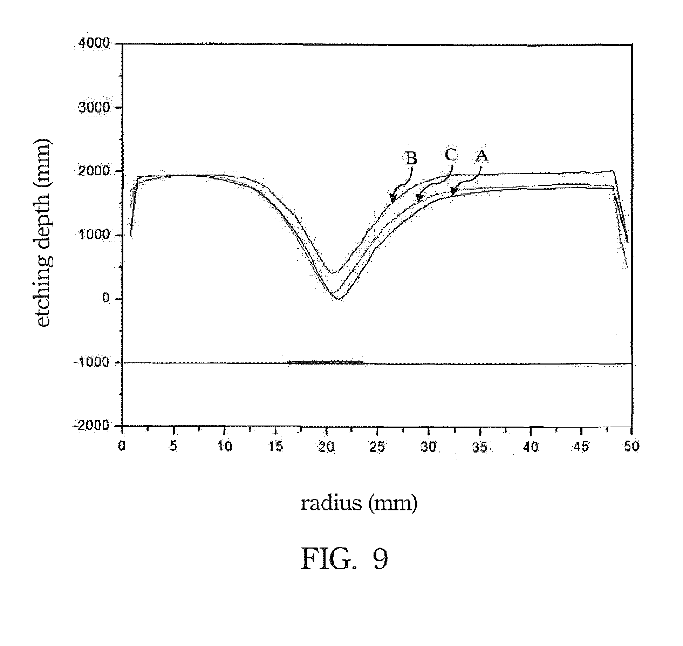

In the same testing conditions (such as testing time and testing power), the etching profiles of the different target structures after sputtering are shown in FIG. 9. In FIG. 9, the consumption rate of the experimental group A with no magnetic layer is obvious faster than that of the experimental group C with the second circle magnetic layer, and the consumption rate of the experimental group C with the second circle magnetic layer is obvious faster than that of the experimental group B with the first circle magnetic layer. The area of the first circle magnetic layer in the experimental group B is larger than that of the second circle magnetic layer in the experimental group C. In other words, for the same sputtering duration, it is known that the etching depth of the metal layer in the experimental group A is greater than that of the metal layer in the experimental group C according to the etching depth curves A and C of the metal layer, and the etching depth of the metal layer in the experimental group C is greater than that of the metal layer in the experimental group B according to the etching depth curves B and C of the metal layer.

The composite target and the method for manufacturing the same can dynamically adjust a magnetic field condition according to a customized target shape and the magnetic field condition generated by a sputtering apparatus to make the utilization rate of the composite target be twice or triple as large as that of the prior art. In addition, the present invention adjusts the magnetic field line distribution by disposing the magnetic layer on or embedding the magnetic layer in the substrate layer.

## Claims

1. A method for manufacturing a composite target, which manufactures the composite target according an etching condition of a waste target, wherein the waste target is generated after an original target at least having a substrate layer and a metal layer is processed through a sputtering process by a sputtering apparatus with a first magnetic field line distribution, and the method includes:
determining the etching condition of the waste target caused by the first magnetic field line distribution to decide a second magnetic field line distribution, wherein the second magnetic field line distribution is used to adjust the first magnetic field line distribution applied on the composite target while being disposed on the sputtering apparatus;
disposing a magnetic layer corresponding to the second magnetic field line distribution on the substrate layer of the original target;
disposing the metal layer on the magnetic layer and the substrate layer; and
disposing a connection layer among the substrate layer, the magnetic layer and the metal layer to combine the substrate layer, the magnetic layer and the metal layer to form the composite target,
when the composite target is used to perform the sputtering process, the composite target with the second magnetic field line distribution adjusts the first magnetic field line distribution applied on the composite target into a third magnetic field line distribution.

2. The method for manufacturing a composite target according to claim 1, wherein the step of disposing the magnetic layer is performed by locally forming the magnetic layer on the substrate layer to form the second magnetic field line distribution on the composite target.

3. The method for manufacturing a composite target according to claim 2, wherein the step of disposing the magnetic layer includes embedding the magnetic layer in the substrate layer to form the second magnetic field line distribution on the composite target.

4. The method for manufacturing a composite target according to claim 1, wherein a density of the third magnetic field line distribution is less than a density of the first magnetic field line distribution, and a curve of the third magnetic field line distribution is smoother than a curve of the first magnetic field line distribution, so as to make a magnetic field line area of the third magnetic field line distribution parallel to the metal layer be broader than a magnetic field line area of the first magnetic field line distribution parallel to the metal layer.

5. A composite target, which is provided to a sputtering apparatus with a first magnetic field line distribution for sputtering, wherein the composite target includes:
a substrate layer including an embarkation surface and a carrying surface, wherein the embarkation surface is used to embark on the sputtering apparatus;
a magnetic layer disposed on the carrying surface of the substrate layer, wherein the magnetic layer generates a second magnetic field line distribution, and the second magnetic field line distribution is used to adjust the first magnetic field line distribution to a third magnetic field line distribution;
a metal layer disposed on the magnetic layer and the carrying surface of the substrate layer, wherein the metal layer has the second magnetic field line distribution; and
a connection layer disposed among the substrate layer, the magnetic layer and the metal layer to connect the substrate layer, the magnetic layer and the metal layer.

6. The composite target according to claim 5, wherein a shape of the magnetic layer 14 is a lattice shape, a grid shape or a ring shape and is used to form the second magnetic field line distribution.

7. The composite target according to claim 6, wherein the substrate layer further includes at least one of a trench and a hole, which the magnetic layer can be embedded in.

8. The composite target according to claim 7, wherein the connection layer is filled into a space of the at least one of the trench and the hole, which is not filled up with the magnetic layer, to connect the substrate layer, the magnetic layer and the metal layer.

9. The composite target according to claim 5, wherein a material of the metal layer is selected from a group consisting of Al, Cu, Mo, Ti, and any combinations thereof.

10. The composite target according to claim 5, wherein a material of the magnetic layer is selected from a magnetic material group consisting of Fe, Co, Ni, stainless steel, and any combinations thereof.
